# FASCICULE DE BREVET EUROPEEN

(11) **EP 2 936 108 B1**
(45) Date de publication et mention de la délivrance du brevet: **16.10.2019**
(21) Numéro de dépôt: 13818350.4
(22) Date de dépôt: 18.12.2013
(51) Int. Cl.: G01M 5/00, G01N 27/02, G01R 31/11, G01N 17/00

(54) **PROCÉDÉ POUR SURVEILLER UN OUVRAGE DE GÉNIE CIVIL**
VERFAHREN ZUR ÜBERWACHUNG EINES BAUWERKS
METHOD FOR MONITORING A CIVIL ENGINEERING CONSTRUCTION

(30) Priorité: 20.12.2012 FR 1262393
(43) Date de publication de la demande: 28.10.2015
(73) Titulaire: SOLETANCHE FREYSSINET, 92500 Rueil Malmaison (FR); Institut Français des Sciences et Technologies des Transports, de l'Aménagement et des Réseaux, 77447 Marne la Vallee Cedex 2 (FR)
(72) Inventeur: TAILLADE, Frédéric, F-92140 Clamart (FR); HOVHANESSIAN, Gilles, F-92160 Antony (FR); FREITAG, Nicolas, F-91400 Orsay (FR)
(74) Mandataire: Cabinet Plasseraud
(86) Numéro de dépôt international: PCT/FR2013/053169
(87) Numéro de publication internationale: WO 2014/096706

(56) Documents cités:
- EP-A1- 1 830 181
- WO-A1-94/27129
- WO-A1-2007/135162
- DE-C1- 10 102 577
- FR-A1- 2 972 264
- JP-A- H08 201 324
- US-A1- 2006 086 197

## Description

### Domaine Technique

La présente invention est relative aux procédés et systèmes pour surveiller un ouvrage de génie civil, en particulier un ouvrage comportant des armatures de renfort métalliques.

### Art Antérieur

L'usage d'armatures métalliques est très courant dans les ouvrages de génie civil. Par exemple, on utilise des câbles métalliques sous contrainte pour améliorer les propriétés mécaniques de certains ouvrages en béton. Un autre exemple consiste à placer des bandes métalliques ou des treillis métalliques dans des ouvrages de type sol renforcé. Encore un autre exemple consiste à utiliser des tirants d'ancrage métalliques pour maintenir ou contraindre une structure ou un bâtiment.

Les armatures métalliques en acier présentent de très bonnes propriétés mécaniques mais ont pour inconvénient d'être soumises aux attaques de la corrosion. Il est connu de protéger de telles armatures métalliques en acier par une galvanisation, par une métallisation, par une protection cathodique ou par une autre méthode de passivation ou de gainage. Cependant, il apparaît nécessaire de surveiller, au cours du temps, l'état de santé de telles armatures métalliques, notamment pour les ouvrages dont la durée d'utilisation peut dépasser plusieurs dizaines d'années. Il est préférable de pouvoir procéder à une telle surveillance de manière non intrusive, c'est-à-dire sans intervenir directement dans le corps de l'ouvrage.

Il a déjà été proposé des méthodes non intrusives pour surveiller l'état de santé des armatures métalliques, notamment à partir du document FHWA-NHI-09-087, basées sur le prélèvement d'éprouvettes témoin ou sur des mesures résistives. Cependant les méthodes de mesures résistives ne permettent pas d'identifier un défaut structurel local comme une perte de matière locale ou une entaille qui peuvent se manifester dans une ou plusieurs armatures de l'ouvrage. Le prélèvement d'éprouvettes témoin quant à lui n'apporte qu'une information parcellaire, et de nombreux ouvrages existant ne sont pas munis de telles éprouvettes.

Il est donc apparu un besoin d'améliorer les solutions non intrusives connues pour surveiller l'état de santé des armatures métalliques et pouvoir détecter un défaut structurel éventuel lié à la corrosion et/ou au vieillissement par exemple.

Le document FR2972264 décrit une méthode pour déterminer et localiser des défauts électriques par réflectométrie dans un réseau de structure métalliques. Le document DE10102577 décrit une méthode similaire appliquée à une structure en béton. Dans le document JPH08201324 une méthode pour mesurer l'impédance du béton est proposé pour déterminer l'état dudit béton.

### Résumé de l'invention

A cet effet, selon la présente invention, il est proposé un procédé pour surveiller un ouvrage de génie civil, comprenant au moins une première armature métallique contribuant à la tenue mécanique dudit ouvrage, et un élément conducteur de référence, formant avec la première armature un couple de deux conducteurs, lesdits deux conducteurs étant séparés par du matériau diélectrique sur une partie de leur longueur, ledit matériau diélectrique étant formé par un matériau de construction ou de remblai, la première armature et l'élément conducteur de référence ayant chacun une première extrémité électriquement accessible, le procédé comprenant :
A- injecter au moins un signal électrique incident appliqué en différentiel entre les premières extrémités de la première armature et de l'élément conducteur de référence,
B- capter des signaux réfléchis revenant le long des conducteurs, mesurés entre les premières extrémités de la première armature et de l'élément conducteur de référence,
C- analyser les signaux réfléchis, pour en déduire un la présence d'un défaut structurel éventuel localisé de la première armature, ainsi que la localisation de ce défaut le long de la première armature, dans lequel l'élément conducteur de référence est formé par une deuxième armature.

Grâce à ces dispositions, on utilise les propriétés de propagation des signaux le long des conducteurs, et il est possible d'identifier un défaut structurel, même très ponctuel ou localisé sur la longueur de l'armature ; on peut aussi identifier la position d'un tel éventuel défaut le long de l'armature ; on peut en outre identifier une altération de la longueur de l'armature, par exemple dû à une coupure ou à une portion totalement corrodée.

Dans divers modes de réalisation de l'invention, on peut éventuellement avoir recours en outre à l'une et/ou à l'autre des dispositions suivantes, prise isolément ou en combinaison :
- on compare les signaux réfléchis à des signaux de référence ; moyennant quoi on utilise des signaux de référence sans utiliser des éléments de comparaison absolus ;
- l'élément conducteur de référence peut être formé par un élément non soumis à la corrosion; moyennant quoi cet élément non soumis à la corrosion est un témoin inaltérable et un défaut éventuel révélé par les signaux réfléchis peut être attribué sans ambiguïté à la première armature ;
- l'élément conducteur de référence est formé par une deuxième armature ; de sorte que le procédé peut être mise en oeuvre sur des ouvrages pré-existants, le procédé utilisant alors uniquement les armatures métalliques de renfort d'origine ;
- on compare les signaux réfléchis à des signaux réfléchis précédemment enregistrés ; de sorte que l'on peut effectuer un suivi dans le temps des caractéristiques et de l'état de santé de l'armature en fonction du vieillissement de l'ouvrage ;
- on compare les signaux réfléchis à des signaux réfléchis relatifs à un autre couple de conducteurs ; moyennant quoi il est possible d'effectuer un suivi dans l'espace de l'ouvrage, et en particulier il est possible d'utiliser des mesures relatives pour identifier les armatures les plus endommagées parmi une pluralité d'armatures, mais aussi pour apprécier l'état de vieillissement de l'ouvrage à partir du niveau d'hétérogénéité de ces mesures comparatives;
- on peut utiliser une méthode de réflectométrie temporelle pour l'analyse et la comparaison des signaux réfléchis ; moyennant quoi il est possible de déterminer la position d'un défaut structurel sur la longueur de l'armature ;
- le signal électrique incident peut comprendre plusieurs composantes fréquentielles prédéterminées et on procède à une analyse des composantes fréquentielles des signaux réfléchis ; moyennant quoi une telle analyse fréquentielle est une méthode plus robuste qu'une méthode temporelle pure ;
- la méthode peut comprendre en outre une étape préalable avant l'étape A- : A0- fournir un accès pour établir un contact électrique avec chacune des premières extrémités de la première armature et de l'élément conducteur de référence ; moyennant quoi on peut utiliser le procédé sur des ouvrages existants, y compris des ouvrages anciens ;
- la méthode peut comprendre en outre une étape complémentaire dans laquelle on fournit un accès aux deuxièmes extrémités des deux conducteurs, on capte des signaux transmis le long de conducteurs jusqu'aux dites deuxièmes extrémités et on analyse lesdits signaux transmis en référence à des signaux transmis de référence ; moyennant quoi on peut fiabiliser la détection de défaut structurel localisé par la complémentarité de l'analyse des signaux réfléchis et des signaux transmis ;
- l'ouvrage est un ouvrage en sol renforcé, le matériau diélectrique étant formé par le sol, les armatures s'étendant principalement selon une direction longitudinale depuis un parement d'ouvrage, et étant sensiblement parallèles espacées d'une distance D, lesdites armatures étant par exemple des clous géotechniques ou des tirants d'ancrage ; de sorte que l'on peut appliquer le procédé à nombre d'ouvrages en sol renforcé y compris déjà existants ;
- l'ouvrage peut comprendre un parement et un remblai, et peut comprendre une successions de lits d'armatures dont au moins une partie est connectée au parement et de couches de sol mises en place par remblaiement et formant ledit remblai, lesdites armatures étant par exemple des bandes métalliques lisses ou munies de nervures; moyennant quoi l'application du procédé est particulièrement adaptée aux ouvrages en sol renforcé à base de parement et de sol remblayé ;
- les armatures sont connectées mécaniquement au parement, et un conducteur électrique auxiliaire permet de relier électriquement chaque armature à un contact électrique accessible depuis la surface extérieure du parement ; de sorte que les plaques de parement peuvent être prédisposées pour une mise en oeuvre aisée du procédé ;
- les armatures présentent une longueur comprise entre 2m et 20m et la distance D est comprise entre 0,2 m et 3,0 m ; de sorte que le procédé peut être utilisée pour une grande variété d'armatures et d'ouvrages;
- l'ouvrage peut comprendre une gaine de précontrainte comprenant au moins un câble métallique de précontrainte formant la première armature, et un conducteur électrique formant le conducteur de référence, séparés par un coulis de remplissage, ledit conducteur électrique étant par exemple un fil électrique gainé; on peut ainsi appliquer le procédé à des systèmes de câbles de précontrainte pour les ouvrages en béton précontraint.

### Brève description des dessins

D'autres aspects, buts et avantages de l'invention apparaîtront à la lecture de la description suivante de ses modes de réalisation de l'invention, donnés à titre d'exemples non limitatifs. L'invention sera également mieux comprise en regard des dessins joints sur lesquels :
- la figure 1 est une vue schématique en coupe d'un ouvrage de type sol renforcé dans lequel le procédé selon l'invention peut être mise en oeuvre,
- la figure 2 est une vue plus détaillée de l'ouvrage de la figure 1,
- la figure 3 est une vue schématique en coupe d'un ouvrage de type structure en béton précontraint représentant un deuxième mode de réalisation dans lequel le procédé selon l'invention peut être mise en oeuvre,

- la figure 4 montre un détail en coupe transversale selon la ligne de coupe IV-IV sur la Figure 3,
- la figure 5 montre une armature affectée d'un défaut structurel,
- la figure 6 montre un exemple de chronogrammes des signaux mis en oeuvre,
- la figure 7 montre une vue détaillée en coupe d'un élément de parement de l'ouvrage de la Figure 1,
- la figure 8 illustre le procédé objet de l'invention,
- la figure 9 est une vue schématique en coupe d'un ouvrage stabilisé par des tirants géotechniques représentant un troisième mode de réalisation dans lequel le procédé selon l'invention peut être mise en oeuvre,
- la figure 10 est une vue schématique en coupe d'un ouvrage stabilisé par clouage géotechnique représentant un quatrième mode de réalisation dans lequel le procédé selon l'invention peut être mise en oeuvre.

### Description détaillée de l'invention

Sur les différentes figures, les mêmes références désignent des éléments identiques ou similaires.

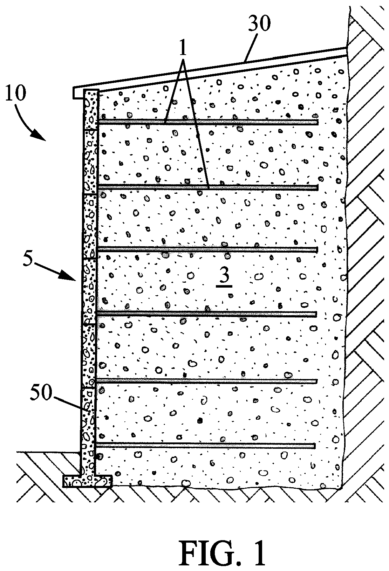

La figure 1 montre un ouvrage **10** de type sol renforcé, comprenant un parement **5,** construit par exemple à base de plaques de béton **50** préfabriquées, et une zone de remblai **3** constitué de terre, sables, graviers ou tous matériaux de construction disponibles pour former la zone de remblai **3.**

Ladite zone de remblai est renforcée par des armatures métalliques **1** comme connu dans l'art, les armatures métalliques pouvant être connectées au parement **5** de manière connue.

Dans la pratique, on édifie ce genre d'ouvrage par couches successives ; on installe des plaques préfabriquées de parement sur une certaine hauteur, on installe une pluralité d'armatures 1 au même niveau horizontal, ce qu'on appelle un 'lit' d'armatures, que l'on ancre chacune dans la plaque de parement en vis-à-vis ; puis on vient apporter du matériau de remblai 3 au-dessus des armatures métalliques installées jusqu'à une hauteur voisine de la portion supérieure des plaques de parement installées ; le cas échéant on tasse le matériau de remblai avec un engin de compactage. Puis on réitère les opérations précédentes, couche après couche jusqu'à la hauteur prévue pour l'ouvrage.

Ce type d'ouvrage peut être, à titre d'exemple, un barrage, une digue, une culée de pont, un soubassement de voie de chemin de fer ou de voie routière, une berge de canal, un ouvrage de rétention de fluides divers et/ou matières émettrices de lixiviats, une construction destinée à élargir ou rehausser un ouvrage existant, un talus circonscrit par un parement ou plus généralement tout autre ouvrage de génie civil.

Ce type d'ouvrage peut être recouvert sur sa portion supérieure par une couverture **30** destinée à empêcher la pénétration de fluides de ruissellement ou de précipitation directement dans le remblai **3** de l'ouvrage.

Les armatures **1** susmentionnées sont réalisées dans la pratique en acier galvanisé qui s'avère être le meilleur compromis en termes de propriétés mécaniques et de résistance à la corrosion. Toutefois ce type d'ouvrage a en général une durée d'utilisation très importante typiquement supérieure à plusieurs dizaines d'années. Cette durée d'utilisation est généralement sans dégradation du niveau de sécurité, mais dans certains cas des facteurs extérieurs peuvent altérer la durabilité des renforcements.

Les armatures métalliques en acier galvanisé peuvent alors être sujettes à des attaques de corrosion qui peuvent varier dans l'espace de l'ouvrage et dans le temps. En particulier, la zone proche **31** du parement 5 peut être soumise à des agressions de corrosion plus importantes que le corps du remblai. De même, selon les conditions météorologiques et/ou les saisons, l'ouvrage peut être soumis à du ruissellement de sels de déverglaçage, ou à d'autres produits chimiques particulièrement corrosifs, en particulier dans les cas où la couverture 30 est absente ou ne joue pas correctement son rôle.

Il s'ensuit que la corrosion peut ne pas être homogène dans l'espace et dans le temps, et elle peut provoquer des défauts très localisés.

Par conséquent, il est apparu important de surveiller le bon état des armatures métalliques **1** afin de s'assurer que leur état puisse garantir les propriétés mécaniques de l'ouvrage tout au long de sa durée d'utilisation.

Avantageusement selon la présente invention, on procède à la surveillance de l'état des armatures par un procédé non intrusif.

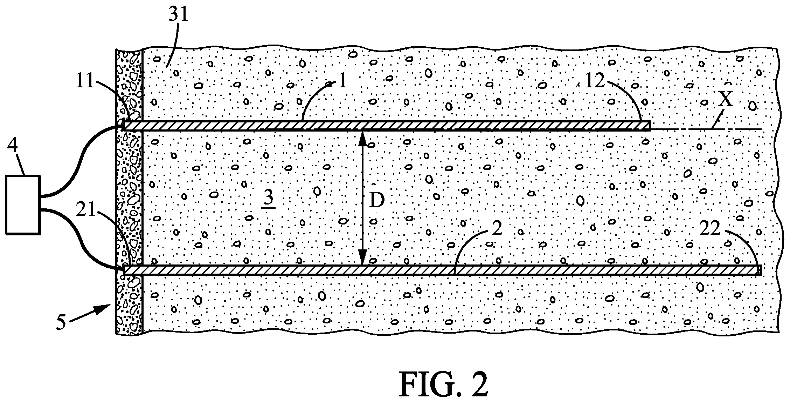

Comme représenté à la figure 2, qui montre un couple d'armatures voisines parmi la pluralité d'armatures contenues dans l'ouvrage, on utilise un appareillage électronique **4** raccordé électriquement aux deux armatures représentées, dont l'une au moins participe à la tenue mécanique de l'ouvrage. Les deux armatures représentées peuvent être l'une au-dessus de l'autre, l'une à côté de l'autre, en biais ou toute autre disposition, même non parallèles entre elles ou non perpendiculaires au parement.

L'appareillage électronique **4** est destiné à injecter au moins un signal électrique incident aux bornes d'un couple d'armatures **1,2** voisines dans la zone de remblai, l'injection de signal étant faite préférentiellement en mode différentiel. Le matériau de remblai **3** ou de construction qui sépare les deux armatures 1,2 constitue un matériau diélectrique dont la permittivité relative varie avec la consistance et/ou l'humidité du matériau de remblai et/ou d'autres paramètres secondaires.

Dans l'exemple illustré, chacune des deux armatures 1,2 s'étend selon la direction axiale X perpendiculaire à la surface du parement, entre une première extrémité **11,12** au niveau du parement et une deuxième extrémité **21,22** opposés à la première et située dans le corps du remblai

Les deux armatures **1,2** sont séparées d'une distance **D,** qui peut typiquement se situer dans un intervalle de 0,2m à 3m, préférentiellement entre 0,5m et 1m, et de manière encore plus préférée entre 0,7m et 0,8m. Il faut noter que, une fois l'ouvrage construit, la position relative des deux armatures **1,2** n'évolue pas dans le temps.

Les deux armatures **1,2** peuvent présenter des longueurs différentes ou de manière préférée une longueur semblable, le procédé pouvant être mis en oeuvre dans les deux cas. Les armatures peuvent présenter comme des bandes métalliques lisses ou munies de nervures, avec une épaisseur de quelques millimètres, par exemple 5mm, et une largeur de quelques centimètres, par exemple 5cm.

Les deux armatures **1,2** sont électriquement conductrices et forment un couple de conducteurs. Ce couple de conducteurs forme avec le matériau diélectrique **3** du remblai une ligne de transmission électrique à laquelle on applique une méthode de réflectométrie.

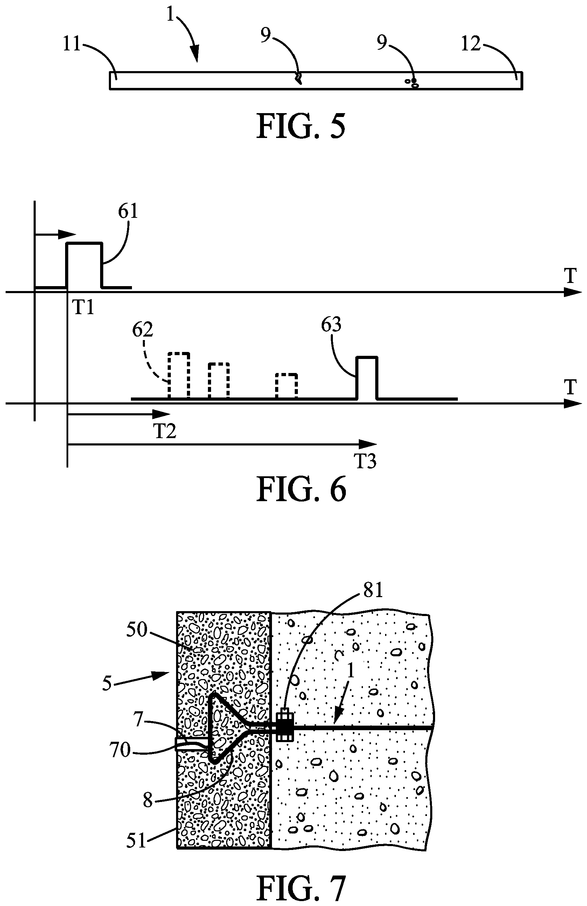

Plus précisément, en référence à la figure 6, le procédé comprend typiquement les étapes :
**A-** injecter un signal électrique incident **61** appliqué en différentiel entre les premières extrémités **11,21** des armatures 1,2,
**B-** capter des signaux réfléchis 62,63 revenant le long des conducteurs, mesurés entre les dites premières extrémités,
**C-** analyser les signaux réfléchis, pour en déduire un défaut structurel éventuel **9** localisé de la première armature.

Dans l'étape C-, avantageusement, on peut comparer les signaux réfléchis à des signaux de référence, sans référence à des éléments de comparaison absolus.

De plus, on peut en déduire la présence d'un défaut structurel éventuel 9 localisé de la première armature, ainsi que la localisation de ce défaut le long de la première armature.

Le fait de travailler sur un couple d'armatures, c'est-à-dire sur un couple de conducteurs, en mode différentiel, s'est avéré fructueux alors que des tentatives faites en injectant un signal sur une seule armature n'a pas conduit à des résultats satisfaisants.

L'appareillage électronique **4** peut être composé d'une association d'un générateur d'impulsions et d'un analyseur de signaux (oscilloscope numérique plus post-traitement), par exemple en cas d'utilisation de la réflectométrie temporelle, ou bien l'appareillage électronique 4 peut être formé par un analyseur de réseau par exemple dans le cas d'utilisation de la réflectométrie fréquentielle.

Les signaux de référence mentionnés à l'étape C-peuvent correspondre à des signaux réfléchis par un couple d'armature à l'état neuf, pour une pluralité de valeur de permittivité relative du matériau de remblai, par exemple pour des valeurs de permittivité relative allant 1 à 80 (par exemple de valeur 7 pour un coulis de ciment). Selon une alternative, lesdits signaux de référence peuvent être des signaux mesurés sur ce couple d'armatures particulier alors que l'ouvrage était dans son état initial, et l'effet de la variation de permittivité relative peut être pris en compte par calcul ou extrapolation basée sur des résultats antérieurs.

La deuxième armature **2** peut être formée par un élément conducteur de référence ne participant pas nécessairement à la tenue mécanique. Dans un cas particulier, ce conducteur de référence peut être choisi pour ne pas être soumis à la corrosion et former ainsi un témoin inaltérable, auquel cas les défauts éventuels seront affectés de manière non ambiguë à la première armature métallique **1.**

En référence à la figure 6, qui illustre un exemple de chronographes relatifs à une méthode de réflectométrie temporelle, le signal électrique incident **61** est injecté à l'instant **T1**. En temps normal, le signal réfléchi par le couple d'armature comprend simplement un écho **63** revenant au niveau des premières extrémités à l'instant **T3,** ce qui correspond à la réflexion sur la deuxième extrémité **12.** Dans le cas de la présence de défaut structurel localisé **9,** tel qu'illustré à la figure 5, des échos supplémentaires **62** (dessinés en trait pointillés) reviennent vers les premières extrémités à l'instant T2 dans l'exemple illustré, généralement avant l'écho principal normal. La position temporelle de l'écho à l'instant T2 permet d'identifier et de localiser la présence d'un défaut 9 le long de l'armature 1. Par ailleurs, la position temporelle de l'écho principal à l'instant T3 permet de vérifier que la longueur de l'armature (ou des deux armatures) n'a pas été modifiée.

Le signal électrique incident **61** peut être une trame courte comprenant plusieurs composantes fréquentielles, ou peut s'apparenter à une impulsion de type 'Dirac', encore à un train d'impulsions mono fréquentielles, cette liste n'étant pas limitative.

Dans une alternative de méthode de réflectométrie fréquentielle (non représentée aux figures), le signal électrique incident **61** comprend une pluralité de composantes fréquentielles différentes. L'analyse spectrale des signaux réfléchis, en comparaison avec des spectres de référence permet de détecter une condition anormale de l'armature et d'en déduire la présence d'une ou plusieurs anomalies.

En particulier, la captation des signaux réfléchis peut se produire de manière simultanée avec l'injection du signal incident.

À titre d'exemple non limitatif, on pourra utiliser des composantes fréquentielles comprises entre 5kHz et 9GHz. Ce choix peut être fait plus précisément si la nature du matériau diélectrique est bien connue ou n'évolue pas dans le temps.

La présence de défaut(s) provoque une modification du spectre fréquentiel ; des pics d'absorption attendus peuvent avoir été déplacés en fréquence, ou de nouveaux pics d'absorption peuvent apparaître.

Des spectres de référence ayant été mesurés sur l'ouvrage alors que celui-ci était neuf peuvent servir de référence ; de plus, des modifications type de spectre liées à des défauts 'simples' (coupure) peuvent également être intégrées dans une base de données de spectres de référence.

L'apparition de raies spectrales non attendues permet d'identifier un éventuel défaut structurel ; l'intensité et l'étalement de cette raie non attendue permet de localiser la présence d'un défaut 9 le long de l'armature 1.

On utilise classiquement un appareil de type analyseur de réseau pour faire des acquisitions de spectres.

Bien sûr on pourra utiliser une combinaison des deux méthodes, temporelle et fréquentielle, afin d'accroître la précision des mesures effectuées.

La méthode peut être mise en oeuvre pour des ouvrages existants récents ou vieux de plusieurs années. Dans ce cas de figure, on pourra perforer la plaque de béton 50 depuis la façade pour atteindre la pièce d'ancrage afin de raccorder électriquement l'appareillage électronique 4 à l'armature logée dans le remblai.

La méthode en question peut également être appliquée sur un ouvrage neuf, auquel cas on prévoira une prédisposition des plaques de béton **50,** comme ceci est illustré à la figure 7. Plus précisément, l'armature **1** est destinée à être couplée mécaniquement à un ancrage **8** inséré à la coulée de la plaque en béton **50.** De plus, un raccordement électrique sous la forme ici d'un conducteur **7** met en connexion électrique la pièce d'ancrage **8** avec une borne de raccordement **70** agencée au voisinage de la façade extérieure **51** du parement 5. Cette borne de raccordement **70** peut être logée dans un connecteur protégé de l'environnement et notamment des intempéries, qui peut être reçu dans un creux ménagé dans la façade du parement 5. La pièce d'ancrage **8** est électriquement raccordée à l'armature 1 grâce à la liaison boulonnée **81.**

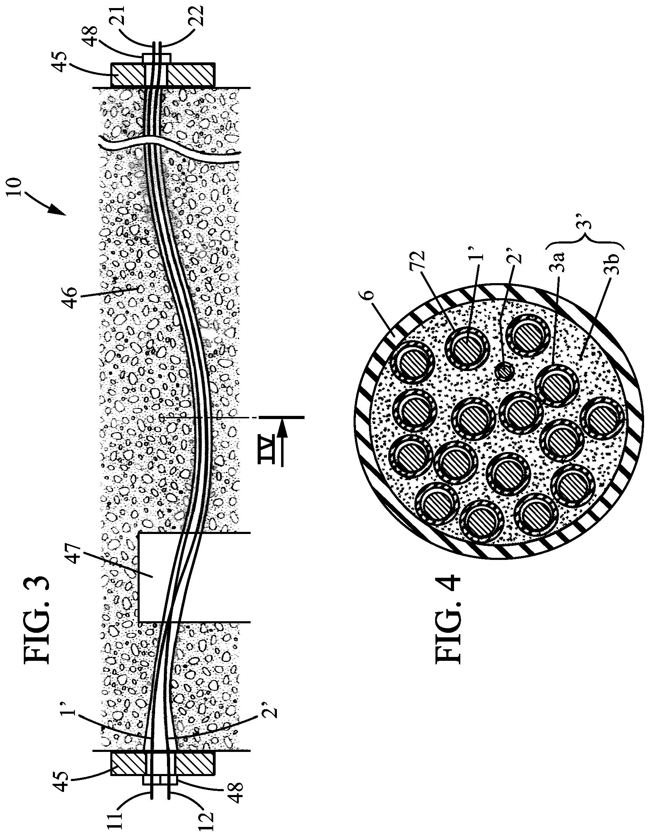

Dans un autre mode de réalisation représentée aux figures 3 et 4, on utilise le procédé décrit ci-dessus appliqué à un dispositif de précontrainte d'un ouvrage en béton précontraint. Une gaine de précontrainte **6** comporte une pluralité de câbles métalliques, lesdits câbles métalliques pouvant être gainés ou non.

Chaque câble métallique gainé comprend une âme métallique **1',** le cas échant à l'intérieur d'une gaine protectrice **72,3a** en matériau synthétique, qui peut être remplie de graisse suivant les cas d'application. La gaine de précontrainte **6** comporte de plus au moins un conducteur métallique de référence **2',** en l'occurrence un fil de cuivre gainé d'un isolant synthétique protecteur. Après insertion des câbles métalliques et du (ou des) conducteur(s) de référence, on injecte un coulis de ciment **3b** à l'intérieur de la gaine qui se solidifie après un certain temps, un tel coulis de ciment **3b** constitue, avec la gaine protectrice **3a** si elle est présente, un matériau diélectrique **3'** qui sépare les câbles métalliques gainés **1'** et le (ou les) conducteur(s) de référence **2'.**

A chacune des extrémités de la gaine de précontrainte, **6** est disposée une plaque d'appui **45** sur laquelle viennent s'appuyer des systèmes de mors **48** ancrés sur les câbles métalliques mis en tension comme il est connu dans l'art.

Dans ce mode de réalisation, l'accès aux deuxièmes extrémités des armatures 21,22 est possible, et par conséquent la méthode peut comprendre une étape d'analyse des signaux transmis jusqu'à cette deuxième extrémité. Tout comme dans le cas de signaux réfléchis vers la première extrémité 11,12, l'analyse des signaux transmis jusqu'à la deuxième extrémité 21,22, en particulier l'analyse des différences par rapport à des signaux transmis de référence permettent d'identifier la présence de défaut éventuel, même très localisé, dans l'armature métallique 1,2.

Dans certains cas particuliers comme ceux d'une enceinte de confinement nucléaire, les deuxièmes extrémités 21,22 et les premières extrémités 11,12 peuvent se trouver à proximité, ce qui facilite en pratique la mise en oeuvre de l'aspect susdit.

Il faut noter que le matériau diélectrique **3'** n'est pas forcément homogène sur la longueur des armatures : dans l'exemple de la figure 3, la gaine de précontrainte comprend une portion entourée de béton **46** et une autre portion entourée d'air **47.**

Bien entendu, dans ce mode de réalisation, le conducteur de référence **2'** peut aussi être un câble métallique et la méthode peut être appliquée à tout couple de câbles métalliques de précontrainte existants dans une gaine de précontrainte déjà installée dans un ouvrage.

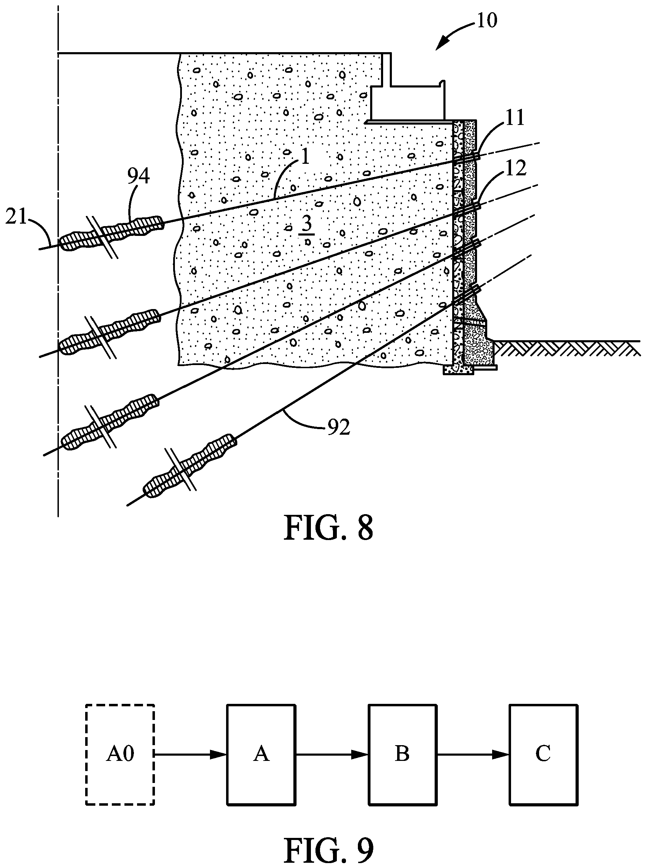

Dans un autre mode de réalisation représenté à la figure 9, il peut être fait appel à un système de renforcement géotechnique, pour lequel on installe des tirants métalliques **92** formant des armatures dans un ouvrage à consolider. Lesdits tirants sont placés à distance les uns des autres pas forcément de manière parallèle entre eux ; la première extrémité est accessible en façade du parement ou de la paroi de l'ouvrage : en effet on boulonne le tirant en appui sur une plaque d'appui. Autour de la deuxième extrémité du tirant est coulé un ciment **94** de scellement qui en se solidifiant assure un ancrage dans la structure environnante.

Dans un autre mode de réalisation non représenté aux figures, les armatures peuvent se présenter comme des tirants traversant un ouvrage à consolider. Dans ce cas, l'accès est possible aux deux extrémités, ce qui permet de travailler à la fois sur les signaux réfléchis et sur les signaux transmis comme déjà indiqué plus haut dans le cas de la gaine de précontrainte.

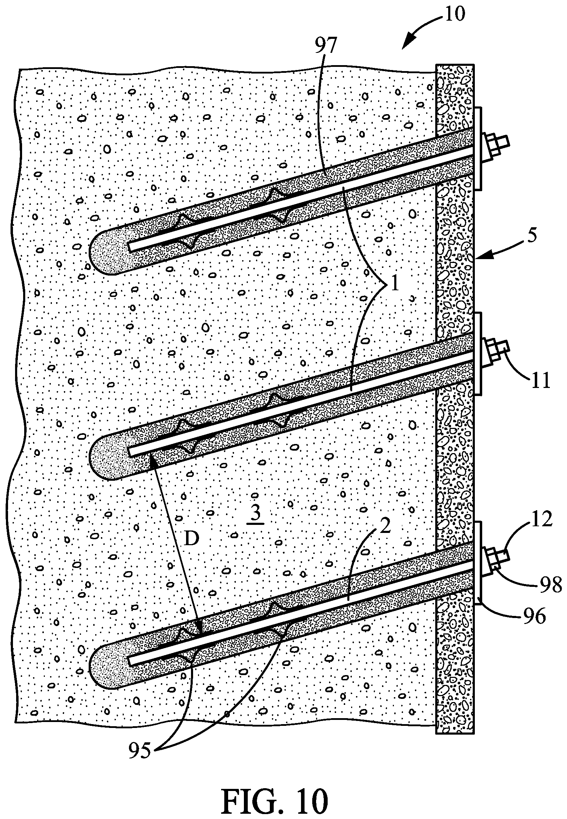

Dans encore un autre mode de réalisation représenté à la figure 10, il peut être fait appel à un système de clouage géotechnique, pour lequel on installe des tiges métalliques appelés 'clous' géotechniques ; ces clous forment des armatures métalliques **1,2** de façon analogue à la description des exemples précédents, et sont séparés par le remblai ou corps d'ouvrage formant un matériau diélectrique. Sur lesdits clous sont fixées des collerettes **95** s'étendant radialement à partir de la tige métallique. Un coulis de ciment **97** est injecté dans les cavités où sont installés les clous. Une plaque de pression **96** est agencée à l'extérieur du parement 5, cette plaque est mise en pression contre le parement par un système de vissage **98** ici sous la forme d'un écrou qui vient se visser sur le filetage prévu sur l'extrémité 11 du clou.

Il est à noter que même si les deuxièmes extrémités 21,22 des armatures sont en contact électrique, le procédé pour la mise en oeuvre de l'invention peut quand même être utilisé.

Il est à noter que dans le cas où on utilise seulement des armatures métalliques contribuant à la tenue mécanique (sans témoin inaltérable), le procédé peut faire appel à une comparaison successive de plusieurs couples d'armatures en vue discriminer si un défaut rencontré peut être attribué à la première ou à la deuxième armature d'un couple considéré.

## Revendications

1. Procédé pour surveiller un ouvrage de génie civil (10), comprenant au moins une première armature (1,1') métallique contribuant à la tenue mécanique dudit ouvrage, et un élément conducteur de référence (2,2'), formant avec la première armature un couple de deux conducteurs, lesdits deux conducteurs étant séparés par du matériau diélectrique (3) sur une partie de leur longueur, ledit matériau diélectrique étant formé par un matériau de construction ou de remblai,
la première armature (1) et l'élément conducteur de référence (2) ayant chacun une première extrémité (11,21) électriquement accessible, le procédé comprenant :
**A-** injecter au moins un signal électrique incident 61 appliqué en différentiel entre les premières extrémités 11,21 de la première armature (1) et de l'élément conducteur de référence (2),
**B-** capter des signaux réfléchis 62,63 revenant le long des conducteurs, mesurés entre les premières extrémités de la première armature (1) et de l'élément conducteur de référence (2),
**C-** analyser les signaux réfléchis, pour en déduire la présence d'un défaut structurel éventuel (9) localisé de la première armature, ainsi que la localisation de ce défaut le long de la première armature,
le procédé étant **caractérisé en ce que** l'élément conducteur de référence est formé par une deuxième armature.

2. Procédé selon la revendication 1, dans lequel à l'étape C-, on compare les signaux réfléchis à des signaux de référence.

3. Procédé selon l'une des revendications 1 à 2, dans lequel l'élément conducteur de référence est formé par un élément non soumis à la corrosion.

4. Procédé selon l'une des revendications 1 à 3, dans lequel on compare les signaux réfléchis à des signaux réfléchis précédemment enregistrés.

5. Procédé selon l'une des revendications 1 à 3, dans lequel on compare les signaux réfléchis à des signaux réfléchis relatifs à un autre couple de conducteurs dans le même ouvrage.

6. Procédé selon l'une des revendications 1 à 5, dans lequel on utilise une méthode de réflectométrie temporelle pour l'analyse ou la comparaison des signaux réfléchis.

7. Procédé selon l'une des revendications 1 à 5, dans lequel le signal électrique incident comprend plusieurs composantes fréquentielles prédéterminées et on analyse les composantes fréquentielles des signaux réfléchis.

8. Procédé selon l'une des revendications 1 à 7, comprenant en outre une étape préalable avant l'étape A- :
**A0-** fournir un accès pour établir un contact électrique avec chacune des premières extrémités de la première armature (1) et de l'élément conducteur de référence (2).

9. Procédé selon l'une des revendications 1 à 8 dans lequel, en outre, on fournit un accès aux deuxièmes extrémités (21,22) des deux conducteurs, on capte des signaux transmis le long de conducteurs jusqu'aux dites deuxièmes extrémités (21,22) et on analyse lesdits signaux transmis en référence à des signaux transmis de référence.

10. Procédé selon l'une des revendications 1 à 8, dans lequel l'ouvrage est un ouvrage en sol renforcé, le matériau diélectrique (3) étant formé par le sol, les armatures s'étendant principalement selon une direction longitudinale (X) depuis un parement (5) d'ouvrage, et étant sensiblement parallèles espacées d'une distance D, lesdites armatures étant par exemple des clous géotechniques ou des tirants d'ancrage.

11. Procédé selon l'une des revendications 1 à 8, dans lequel l'ouvrage comprend un parement (5) et un remblai (3), et comprend une successions de lits d'armatures dont au moins une partie est connectée au parement et de couches de sol mises en place par remblaiement et formant ledit remblai, lesdites armatures étant par exemple des bandes métalliques lisses ou munies de nervures.

12. Procédé selon la revendication 10 ou 11, dans lequel les armatures sont connectées mécaniquement au parement, et un conducteur électrique auxiliaire (7) permet de relier électriquement chaque armature à un contact électrique (70) accessible depuis la surface extérieure du parement ;

13. Procédé selon l'une des revendications 10 à 12, dans lequel les armatures présentent une longueur comprise entre 2m et 20m et la distance D est comprise entre 0,2 m et 3,0 m.

14. Procédé selon l'une des revendications 1 à 8, dans lequel l'ouvrage comprend une gaine de précontrainte comprenant au moins un câble métallique de précontrainte (1') formant la première armature, et un conducteur électrique (2') formant le conducteur de référence, séparés par un coulis de remplissage, ledit conducteur électrique étant par exemple un fil électrique gainé.

## Patentansprüche

1. Verfahren zum Überwachen einer Baukonstruktion (10), umfassend wenigstens eine erste metallische Armatur (1, 1'), welche zum mechanischen Verhalten der Konstruktion beiträgt, sowie ein Referenz-Leiterelement (2, 2'), welches mit der ersten Armatur ein Paar von zwei Leitern bildet, wobei die beiden Leiter durch dielektrisches Material (3) an einem Teil ihrer Länge getrennt sind, wobei das dielektrische Material durch ein Bau- oder Füllmaterial gebildet ist,
wobei die erste Armatur (1) und das Referenz-Leiterelement (2) jeweils ein erstes Ende (11, 21) aufweisen, welches elektrisch zugänglich ist, wobei das Verfahren umfasst:
A- Eingeben von wenigstens einem elektrischen Signal 61, welches gegentaktig zwischen den ersten Enden 11, 21 der ersten Armatur (1) und des Referenz-Leiterelements (2) angelegt wird,
B- Aufnehmen von reflektierten Signalen 62, 63, welche entlang der Leiter zurücklaufen, gemessen zwischen den ersten Enden der ersten Armatur (1) und des Referenz-Leiterelements (2),
C- Analysieren der reflektierten Signale, um dadurch das Vorliegen eines lokalisierten möglichen strukturellen Defekts (9) der ersten Armatur abzuleiten, sowie die Position des Defekts entlang der ersten Armatur,
das Verfahren **dadurch gekennzeichnet, dass** das Referenz-Leiterelement durch eine zweite Armatur gebildet ist.

2. Verfahren nach Anspruch 1, wobei in Schritt C- die reflektierten Signale mit Referenzsignalen verglichen werden.

3. Verfahren nach einem der Ansprüche 1 bis 2, wobei das Referenz-Leiterelement durch ein korrosionsfreies Element gebildet ist.

4. Verfahren nach einem der Ansprüche 1 bis 3, wobei die reflektierten Signale mit zuvor aufgenommenen reflektierten Signalen verglichen werden.

5. Verfahren nach einem der Ansprüche 1 bis 3, wobei die reflektierten Signale mit reflektierten Signalen relativ zu einem anderen Paar von Leitern in derselben Konstruktion verglichen werden.

6. Verfahren nach einem der Ansprüche 1 bis 5, wobei eine Methode einer zeitlichen Reflektometrie für die Analyse oder den Vergleich der reflektierten Signale verwendet wird.

7. Verfahren nach einem der Ansprüche 1 bis 5, wobei das einfallende elektrische Signal mehrere vorbestimmte Frequenzkomponenten umfasst und die Frequenzkomponenten der reflektierten Signale analysiert werden.

8. Verfahren nach einem der Ansprüche 1 bis 7, ferner umfassend einen anfänglichen Schritt vor dem Schritt A-:
A0- Herstellen eines Zugangs, um einen elektrischen Kontakt mit jedem der ersten Enden der ersten Armatur (1) und des Referenz-Leiterelements (2) herzustellen.

9. Verfahren nach einem der Ansprüche 1 bis 8, wobei ferner ein Zugang zu den zweiten Enden (21, 22) der beiden Leiter hergestellt wird, entlang der Leiter bis zu den zweiten Enden (21, 22) übertragene Signale aufgenommen werden und die übertragenen Signale unter Bezugnahme auf übertragene Referenzsignale analysiert werden.

10. Verfahren nach einem der Ansprüche 1 bis 8, wobei die Konstruktion eine Konstruktion aus verstärktem Erdreich ist, das dielektrische Material (3) durch das Erdreich gebildet ist, sich die Armaturen im Wesentlichen entlang einer longitudinalen Richtung (X) bis zu einer Außenverkleidung (5) der Konstruktion erstrecken und im Wesentlichen parallel um eine Distanz D beabstandet sind, wobei die Armaturen beispielsweise geotechnische Nägel oder Ankerbolzen sind.

11. Verfahren nach einem der Ansprüche 1 bis 8, wobei die Konstruktion eine Außenverkleidung (5) und ein Füllmaterial (3) umfasst und eine Abfolge von Armaturbetten umfasst, von welchen wenigstens ein Teil mit der Außenverkleidung verbunden ist, sowie Schichten aus Erdreich, welche durch Aufschütten angelegt sind und das Füllmaterial bilden, wobei die Armaturen beispielsweise glatte oder mit Rippen versehene metallische Bänder sind.

12. Verfahren nach Anspruch 10 oder 11, wobei die Armaturen mechanisch mit der Außenverkleidung verbunden sind und ein elektrischer Hilfsleiter (7) es erlaubt, jede Armatur mit einem elektrischen Kontakt (70) elektrisch zu verbinden, welcher von der Außenfläche der Außenverkleidung her zugänglich ist.

13. Verfahren nach einem der Ansprüche 10 bis 12, wobei die Armaturen eine Länge aufweisen, welche zwischen 2m und 20m beträgt, und die Distanz D zwischen 0,2m und 3,0m beträgt.

14. Verfahren nach einem der Ansprüche 1 bis 8, wobei die Konstruktion eine Vorspannungshülle umfasst, welche wenigstens ein metallisches Vorspannungskabel (1') umfasst, welches die erste Armatur bildet, sowie einen elektrischen Leiter (2'), welcher den Referenzleiter bildet, welche durch eine Füllmasse getrennt sind, wobei der elektrische Leiter beispielsweise ein ummantelter elektrischer Draht ist.

## Claims

1. Method for monitoring a civil engineering construction (10), comprising at least one first metal reinforcement (1, 1') contributing to the mechanical strength of said construction, and a reference conductor element (2, 2') forming, with the first reinforcement, a pair of two conductors, said two conductors being separated by dielectric material (3) over at least a part of the length thereof, said dielectric material being formed by a construction or filling material,
the first reinforcement (1) and the reference conductor element (2) each having an electrically accessible first end (11, 21), the method comprising:
A- injecting at least one incident electrical signal (61) applied differentially between the first ends (11, 21) of the first reinforcement (1) and of the reference conductor element (2),
B- collecting reflected signals (62, 63) returning along the conductors, measured between the first ends of the first reinforcement (1) and of the reference conductor element (2),
C- analysing the reflected signals to deduce therefrom the presence of a localised potential structural defect (9) on the first reinforcement, in addition to the location of this defect along the first reinforcement, the method being **characterised in that** the reference conductor element is formed by a second reinforcement.

2. Method according to claim 1, wherein in step C-, the reflected signals are compared to reference signals.

3. Method according to one of claims 1 to 2, wherein the reference conductor element is formed by an element not subject to corrosion.

4. Method according to one of claims 1 to 3, wherein the reflected signals are compared to previously recorded reflected signals.

5. Method according to one of claims 1 to 3, wherein the reflected signals are compared to reflected signals relating to another pair of conductors in the same construction.

6. Method according to one of claims 1 to 5, wherein a time reflectometry method is used to analyse or compare the reflected signals.

7. Method according to one of claims 1 to 5, wherein the incident electrical signal comprises a plurality of predetermined frequency components and the frequency components of the reflected signals are analysed.

8. Method according to one of claims 1 to 7, further comprising a preliminary step before step A- of:
A0- providing access to establish an electrical contact with each of the first ends of the first reinforcement (1) and of the reference conductor element (2).

9. Method according to one of claims 1 to 8, wherein access is also provided to the second ends (21, 22) of the two conductors, signals transmitted along conductors to said second ends (21, 22) are collected, and said transmitted signals are analysed with reference to reference transmitted signals.

10. Method according to one of claims 1 to 8, wherein the construction is a reinforced ground construction, the dielectric material (3) being formed by the ground, the reinforcements extending mainly in a longitudinal direction (X) from a construction facing (5), and being substantially parallel and spaced apart by a distance D, said reinforcements being, for example, geotechnical nails or strain carriers.

11. Method according to one of claims 1 to 8, wherein the construction comprises a facing (5) and a filling (3), and comprises a succession of beds of reinforcements of which at least a part is connected to the facing and of ground layers put in place by filling and forming said filling, said reinforcements being, for example, smooth or ribbed metal strips.

12. Method according to claim 10 or 11, wherein the reinforcements are mechanically connected to the facing, and an auxiliary electrical conductor (7) makes it possible to electrically link each reinforcement to an electrical contact (70) accessible from the outer surface of the facing.

13. Method according to one of claims 10 to 12, wherein the reinforcements have a length that lies in the range 2 m to 20 m, and the distance D lies in the range 0.2 m to 3.0 m.

14. Method according to one of claims 1 to 8, wherein the construction comprises a prestressing duct comprising at least one prestressing metal tendon (1') forming the first reinforcement, and an electrical conductor (2') forming the reference conductor, separated by a filling grout, said electrical conductor being, for example, a sheathed electrical wire.
